# EUROPEAN PATENT APPLICATION

(11) **EP 2 818 969 A1**
(43) Date of publication of application: **31.12.2014**
(21) Application number: 13275270.0
(22) Date of filing: 29.10.2013
(51) Int. Cl.: G06F 1/24, G06F 1/32

(54) **IC device having false operation preventing function and method of preventing false operation thereof**

(30) Priority: 28.06.2013 KR 20130075678
(71) Applicant: Samsung Electro-Mechanics Co., Ltd., Gyeonggi-do (KR)
(72) Inventor: Cho, Han Jin, 443-743 Gyeonggi-do (KR); Lee, Do Hyung, 443-743 Gyeonggi-do (KR); Kim, Wan Su, 443-743 Gyeonggi-do (KR); Yoon, Dong Sik, 443-743 Gyeonggi-do (KR); Lee, Tae Ha, 443-743 Gyeonggi-do (KR)
(74) Representative: Powell, Timothy John

(57) **Abstract**

Disclosed herein are an integrated circuit (IC) device having a false operation preventing function and a method of preventing a false operation thereof. The IC device includes a power supply unit; a main IC including a power input end receiving power and a first output end outputting a first signal in an active mode and outputting a second signal in a sleep mode; and a power transferring unit connected to the power supply unit, the power input end, and the first output end and supplying the power to the main IC or blocking the power supplied to the main IC, wherein the power transferring unit blocks the power supplied to the power input end when the first signal is continued for a predetermined time or more. Therefore, a false operation of the main IC may be prevented and unnecessary power consumption may be decreased.

## Description

### CROSS REFERENCE(S) TO RELATED APPLICATIONS

This application claims the benefit of Korean Patent Application Serial No. 10-2013-0075678, entitled "IC Device Having False Operation Preventing Function and Method of Preventing False Operation Thereof" filed on June 28, 2013, which is hereby incorporated by reference in its entirety into this application.

### BACKGROUND OF THE INVENTION

### 1. Technical Field

The present invention relates to an integrated circuit (IC) device having a false operation preventing function and a method of preventing a false operation thereof.

### 2. Description of the Related Art

Recently, improvement of portability of electronic devices has become an issue and research into an increase in a battery duration as well as miniaturization and lightness of the electronic devices has been conducted in order to improve the portability of the electronic devices.

Meanwhile, most of the electronic devices are mounted with integrated circuits (ICs). Particularly, the integrated circuits used as a central processing unit (CPU or MCU) consume the second largest power after a display device in most of the electronic devices.

This integrated circuit has decreased power consumption in a scheme in which when the integrated circuit has power applied thereto, it starts a power on reset (POR) to be normally operated, enters a standby mode or a sleep mode in the case in which an operation is not required, and is activated in an active mode in the case in which the operation is required, thereby performing a function.

The integrated circuits performing an operation of converting a mode into the active mode and the sleep mode as described above generally include a regulator therein.

However, due to several factors, a case in which the integrated circuit is falsely operated even though a system including the integrated circuit enters the sleep mode, such that the regulator in the integrated circuit does not enter the sleep mode has occurred. Therefore, a problem that power larger than expected power is unnecessarily consumed has occurred.

However, according to the related art, in the case in which this problem occurs, a method of turning off and then turning on a hardware power supply of the electronic device or forcibly separating and then connecting a battery to allow an electronic device system including the integrated circuit to be power-on-reset cannot but be applied.

This method causes inconvenience to a user. Furthermore, power cannot but be continuously consumed unnecessarily until the user recognizes that this problem has occurred and takes action. Therefore, the development of a technology capable of solving these problems has been demanded.

### [Related Art Document]

### [Patent Document]

(Patent Document 1) Korean Patent Laid-Open Publication No. 2011-0067709
(Patent Document 2) Japanese Patent Laid-Open Publication No. 2012-244569

### SUMMARY OF THE INVENTION

An object of the present invention is to provide an integrated circuit (IC) device having a false operation preventing function capable of automatically resetting an IC at the time of generation of a false operation of the IC.

Another object of the present invention is to provide a method of preventing a false operation of an IC device capable of automatically resetting an IC at the time of generation of the false operation of the IC.

According to an exemplary embodiment of the present invention, there is provided an IC device having a false operation preventing function, including: a power supply unit; a main IC including a power input end receiving power and a first output end outputting a first signal in an active mode and outputting a second signal in a sleep mode; and a power transferring unit connected to the power supply unit, the power input end, and the first output end and supplying the power to the main IC or blocking the power supplied to the main IC, wherein the power transferring unit blocks the power supplied to the power input end when the first signal is continued for a predetermined time or more.

The power transferring unit may include a delay circuit, a regulator, and a first switch.

The regulator may include a first control terminal, an input terminal connected to the power supply unit, and an output terminal connected to the power input end, the first switch may have one end grounded and the other end connected to the first control terminal, and the delay circuit may include an input unit connected to the first output end and an output unit connected to a control terminal of the first switch and output a signal input to the input unit to the output unit after a predetermined delay time elapses.

The first signal may be an H signal and the second signal may be an L signal.

The first signal may be an H signal and the second signal may be an L signal, the regulator may include a first control terminal, an input terminal connected to the power supply unit, and an output terminal connected to the power input end and allow a voltage output to the output terminal to be 0 in the case in which a voltage applied to the first control terminal is 0, the first switch may have one end grounded and the other end connected to the first control terminal, the delay circuit may include an input unit connected to the first output end and an output unit connected to a control terminal of the first switch and output a signal of which a magnitude of a voltage is increased at a predetermined ratio to the output unit when the H signal is applied to the input unit, and the first switch may be changed into a turn-on state when the magnitude of the voltage of the signal applied to the control terminal of the first switch becomes a predetermined reference value or more.

The IC device may further include a resistor connected between the other end of the first switch and the power supply unit.

The power transferring unit may include a delay circuit, a second switch, and a switch control unit.

The second switch may have one end connected to the power supply unit and the other end connected to the power input end and include a second control terminal, the switch control unit may include a signal output end connected to the second control terminal and a signal input end connected to an output unit of the delay circuit, output a signal for turning on the second switch to the signal output end, and block the output of the signal output end when the first signal is input to the signal input end, and the delay circuit may include an input unit connected to the first output end and an output unit connected to the signal input end of the switch control unit and output a signal input to the input unit to the output unit after a predetermined delay time elapses.

The switch control unit may further include a power input unit connected to the power supply unit.

According to another exemplary embodiment of the present invention, there is provided a method of preventing a false operation of an IC device including a main IC including a power input end receiving power and a first output end outputting a first signal in an active mode and outputting a second signal in a sleep mode and a power supply unit, including: blocking the power supplied to the power input end when the first signal is output from the first output end for a predetermined time or more.

### BRIEF DESCRIPTION OF THE DRAWINGS

FIG. 1 is a block diagram schematically showing an integrated circuit (IC) device having a false operation preventing function according to an exemplary embodiment of the present invention;
FIG. 2 is a view schematically showing a signal waveform in the case in which a main IC is normally operated in the IC device having a false operation preventing function according to the exemplary embodiment of the present invention;
FIG, 3 is a view for describing a principle of recovering the main IC to a normal state at the time of generation of a false operation of the main IC in the IC device having a false operation preventing function according to the exemplary embodiment of the present invention; and
FIG. 4 is a block diagram schematically showing an IC device having a false operation preventing function according to another exemplary embodiment of the present invention.

### DESCRIPTION OF THE PREFERRED EMBODIMENTS

Various advantages and features of the present invention and methods accomplishing thereof will become apparent from the following description of exemplary embodiments with reference to the accompanying drawings. However, the present invention may be modified in many different forms and it should not be limited to exemplary embodiments set forth herein. These exemplary embodiments may be provided so that this disclosure will be thorough and complete, and will fully convey the scope of the invention to those skilled in the art. Like reference numerals throughout the description denote like elements.

Terms used in the present specification are for explaining exemplary embodiments rather than limiting the present invention. Unless explicitly described to the contrary, a singular form includes a plural form in the present specification. The word "comprise" and variations such as "comprises" or "comprising," will be understood to imply the inclusion of stated constituents, steps, operations and/or elements but not the exclusion of any other constituents, steps, operations and/or elements.

For simplification and clearness of illustration, a general configuration scheme will be shown in the accompanying drawings, and a detailed description of the feature and the technology well known in the art will be omitted in order to prevent a discussion of exemplary embodiments of the present invention from being unnecessarily obscure. Additionally, components shown in the accompanying drawings are not necessarily shown to scale. For example, sizes of some components shown in the accompanying drawings may be exaggerated as compared with other components in order to assist in understanding of exemplary embodiments of the present invention. Like reference numerals on different drawings will denote like components, and similar reference numerals on different drawings will denote similar components, but are not necessarily limited thereto.

In the specification and the claims, terms such as "first", "second", "third", "fourth", and the like, if any, will be used to distinguish similar components from each other and be used to describe a specific sequence or a generation sequence, but is not necessarily limited thereto. It may be understood that these terms are compatible with each other under an appropriate environment so that exemplary embodiments of the present invention to be described below may be operated in a sequence different from a sequence shown or described herein. Likewise, in the present specification, in the case in which it is described that a method includes a series of steps, a sequence of these steps suggested herein is not necessarily a sequence in which these steps may be executed. That is, any described step may be omitted and/or any other step that is not described herein may be added to the method.

In the specification and the claims, terms such as "left", "right", "front", "rear", "top, "bottom", "over", "under", and the like, if any, do not necessarily indicate relative positions that are not changed, but are used for description. It may be understood that these terms are compatible with each other under an appropriate environment so that exemplary embodiments of the present invention to be described below may be operated in a direction different from a direction shown or described herein. A term "connected" used herein is defined as being directly or indirectly connected in an electrical or non-electrical scheme. Targets described as being "adjacent to" each other may physically contact each other, be close to each other, or be in the same general range or region, in the context in which the above phrase is used. Here, a phrase "in an exemplary embodiment" means the same exemplary embodiment, but is not necessarily limited thereto.

Hereinafter, a configuration and an acting effect of exemplary embodiments of the present invention will be described in more detail with reference to the accompanying drawings.

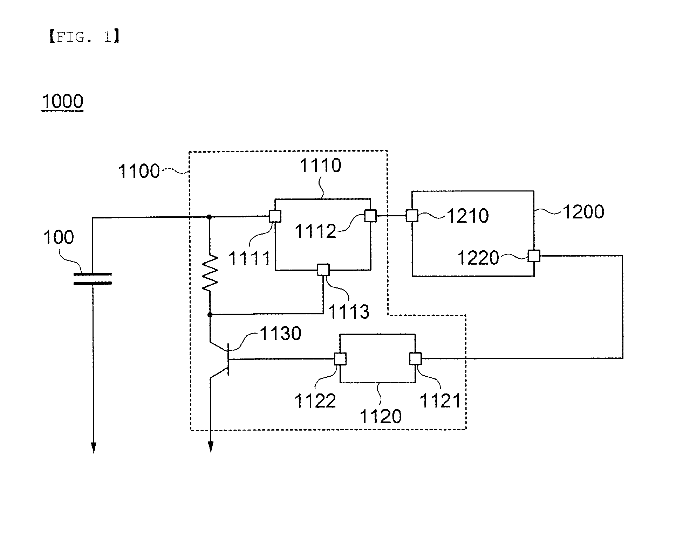

FIG. 1 is a block diagram schematically showing an integrated circuit (IC) device 1000 having a false operation preventing function according to an exemplary embodiment of the present invention.

Referring to FIG. 1, the IC device 1000 having a false operation preventing function according to the exemplary embodiment of the present invention may be configured to include a power supply unit 100, a main IC 1200, and a power transferring unit 1100.

Here, the power supply unit 100, which is a general power supplying unit, may be a commercial power supply connected in a wired scheme or a battery power supply. However, since the IC device 1000 having a false operation preventing function according to the exemplary embodiment of the present invention has an object of preventing unnecessary power consumption, in the case in which the power supply unit 100 is implemented by a battery, an actual profit of the IC device 1000 may be further highlighted.

Next, the main IC 1200 may be implemented by a general integrated circuit including a power input end 1210 to which power is applied. Alternatively, the main IC may also be implemented by an integrated circuit performing operations divided into an active mode and a sleep mode in order to decrease power consumption. As an example, the main IC 1200 may be a central processing unit (CPU), a graphic processing unit (GPU), a micro controller (MCU), or the like.

Particularly, the main IC 1200 may include a first output end 1220 outputting a first signal in the active mode and outputting a second signal in the sleep mode. Here, the main IC 1200 may include an internal regulator 1110 (not shown) connected between the power input end 1210 and the first output end 1220. The internal regulator 1110 may regulate the power applied to the power input end 1210, supply the regulated power to the main IC 1200, and output the first signal to the first output end 1220 in the case in which the main IC 1200 is in the active mode and output the second signal in the case in which the main IC 1200 is in the sleep mode, wherein the first signal is an H signal and the second signal is an L signal.

Next, the power transferring unit 1100 may be connected to the power supply unit 100, the power input end 1210, and the first output end 1220, and perform a function of supplying the power of the power supply unit 100 to the power input end 1210 or blocking the power supplied to the power input end 1210. However, the power transferring unit 1100 of the IC device 1000 having a false operation preventing function according to the exemplary embodiment of the present invention performs an operation of blocking the power supplied to the power input end 1210 in the case in which the first signal described above is continued for a predetermined time or more.

In most of the integrated circuits operated while being changed between the active mode and the sleep mode, a duration of the active mode is much shorter than that of the sleep mode in order to minimize power consumption.

For example, an electronic tag applied to an electronic shelf label (ESL) system is maintained in the sleep mode for most of the time and is changed into the active mode only for several microseconds to wirelessly transmit and receive a data signal and update a changed content to a display device. A micro controller (MCU) mounted in the electronic tag as described above, or the like, may be the main IC 1200 of the IC device 1000 having a false operation preventing function according to the exemplary embodiment of the present invention.

Meanwhile, as shown in FIG. 1, the power transferring unit 1100 may include a delay circuit 1120, a regulator 1110, and a first switch 1130.

The delay circuit 1120 includes an input unit 1121 and an output unit 1122, wherein the input unit 1121 is connected to the first output end 1220 of the main IC 1200 to receive a signal output from the first output end 1220. In addition, the delay circuit 1120 delays the signal input to the input unit 1121 for a predetermined time and then outputs the delayed signal to the output unit 1122.

In addition, the delay circuit 1120 may also output a signal of which a magnitude of a voltage is increased at a predetermined ratio when an H signal is applied to the input unit 1121.

The delay circuit 1120 may be implemented by an RC circuit having a predetermined time constant, a delay circuit, a comparator, a reset IC, or the like.

Next, the regulator 1110 may include a first control terminal 1113, an input terminal 1111, and an output terminal 1112, wherein the input terminal 1111 may be connected to the power supply unit 100 described above, the output terminal 1112 may be connected to the power input end 1210 of the main IC 1200, and the first control terminal 1113 may be connected to one end of a first switch 1130 to be described below.

Here, in the case in which a voltage applied to the first control terminal 1113 is 0, a voltage output to the output terminal 1112 may be 0.

Next, the first switch 1130 may have one end grounded and the other end connected to the first control terminal 1113 and have a control terminal connected to the output unit 1122 of the delay circuit 1120 described above. Here, the first switch 1130 may be implemented by a general transistor turned on when a voltage applied to the control terminal thereof is a predetermined reference value or more, such that one end and the other end thereof are electrically connected to each other.

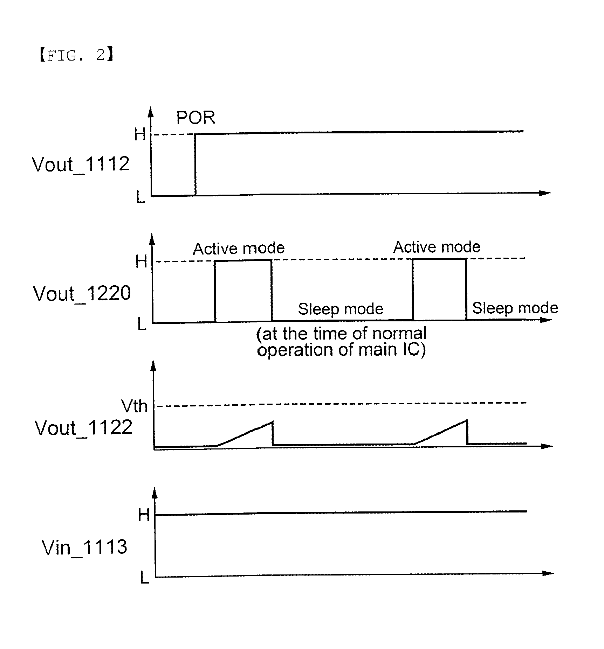

FIG. 2 is a view schematically showing a signal waveform in the case in which a main IC 1200 is normally operated in the IC device 1000 having a false operation preventing function according to the exemplary embodiment of the present invention; and FIG, 3 is a view for describing a principle of recovering the main IC to a normal state at the time of generation of a false operation of the main IC 1200 in the IC device 1000 having a false operation preventing function according to the exemplary embodiment of the present invention.

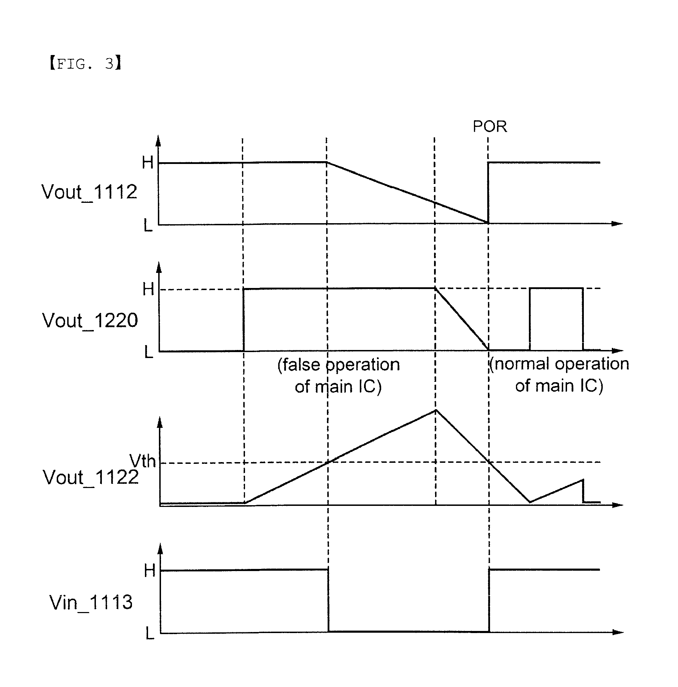

Hereinafter, an operation principle of the IC device 1000 having a false operation preventing function according to the exemplary embodiment of the present invention will be described in detail with reference to FIGS. 2 and 3.

First referring to FIG. 2, when a signal output from the output terminal 1112 of the regulator 1110 is changed from an L signal to an H signal, the main IC 1200 is power-on-reset to start to be normally operated. In this case, a waveform of the signal output from the output terminal 1112 of the regulator 1110 is represented by Vout-1112.

In addition, the normally operated main IC 1200 may be maintained in the active mode for a predetermined time and be again changed into the sleep mode and may be repeatedly operated in the active mode and the sleep mode according to a predetermined period or be changed into the active mode according to a predetermined external signal.

When the main IC 1200 is normally operated as described above, the first output end 1220 of the main IC 1200 may output the first signal in the active mode and output the second signal in the sleep mode. That is, the H signal may be output in the active mode, the L signal may be output in the sleep mode, and a waveform as represented by Vout-1220 of FIG. 2 may be formed.

The signal of the first output end 1220 may be applied to the input unit 1121 of the delay circuit 1120, and the delay circuit 1120 may output a signal waveform as represented by Vout-1122 of FIG. 2 to the output unit 1122. In FIG. 2, a signal waveform in the case in which the H signal is applied to the input unit 1121 of the delay circuit 1120 and a signal of which a magnitude of a voltage is increased at a predetermined ratio is output to the output unit 1122 of the delay circuit 1120 is shown.

In addition, since the main IC 1200 is in a state in which it is normally operated, a peak value of the output signal of the output unit 1122 of the delay circuit 1120 shown in FIG. 2 may be maintained in a state in which it is lower than a threshold voltage (Vth) for turning on the first switch 1130.

Again referring to FIG. 1, a resistor is connected between one end of the first switch 1130 and the power supply unit 100. Therefore, in the case in which the first switch 1130 is in a turn-off state, the H signal is applied to the first control terminal 1113 of the regulator 1110 and in the case in which the first switch 1130 is in a turn-on state, the first control terminal 1113 of the regulator 1110 is grounded.

Therefore, in the case in which the output unit Vout-1122 of the output unit 1122 of the delay circuit 1120 is not equal to or larger than the threshold voltage (Vth) of the first switch 1130, the regulator 1110 continuously supplies the power to the main IC 1200.

Meanwhile, Vin_1113 represents a waveform of the signal input the first control terminal 1113 of the regulator 1110.

On the other hand, referring to FIG. 3, when the main IC 1200 is falsely operated, such that the output signal Vout-1220 output from the first output end 1220 of the main IC 1200 is maintained in an H state for a predetermined time or more, the output signal Vout-1122 of the output unit 1122 of the delay circuit 1120 exceeds the threshold voltage (Vth) of the first switch 1130. Therefore, the first switch 1130 is turned on, such that the first control terminal 1113 of the regulator 1110 becomes a ground state and the output signal Vout-1112 of the output terminal 1112 of the regulator 1110 falls as shown in FIG. 3.

In addition, as a result, the output signal Vout-1220 output from the first output end 1220 of the main IC 1200 is decreased, such that the output signal Vout-1122 of the output unit 1122 of the delay circuit 1120 is decreased. When the output signal Vout-1122 of the output unit 1122 of the delay circuit 1120 becomes less than the threshold voltage (Vth) of the first switch 1130, the signal output from the output terminal 1112 of the regulator 1110 again becomes an H state to power-on-reset the main IC 1200. Therefore, the main IC 1200 that has been falsely operated is reset, such that it may be again operated normally.

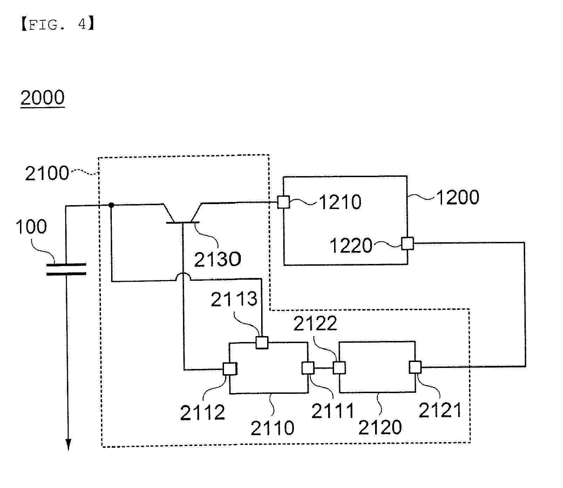

FIG. 4 is a block diagram schematically showing an IC device 2000 having a false operation preventing function according to another exemplary embodiment of the present invention.

Referring to FIG. 4, it may be understood that a power transferring unit 210 may be configured in a form different from that of the power transferring unit 1100 of the IC device 1000 according to the exemplary embodiment of the present invention described above. That is, although the power transferring unit 2100 is the same as the power transferring unit 1100 of the IC device 1000 according to the exemplary embodiment of the present invention described above in that it includes a delay circuit 2120, the power transferring unit 2100 may include a second switch 2130 and a switch control unit 2110.

Here, the second switch 2130 may have one end connected to the power supply unit 100 and the other end connected to the power input end 1210 of the main IC 1200 and include a second control terminal.

In addition, the second switch 2130 may be implemented by a power switch transferring or blocking power.

Meanwhile, the switch control unit 2110 may include a signal output end 2112 and a signal input end 2111.

Here, the signal output end 2112 may be connected to the second control terminal of the second switch 2130 and the signal input end 2111 may be connected to the output unit 2122 of the delay circuit 2120.

In addition, the switch control unit 2110 may output or may not output a signal for turning on the second switch 2130 through the signal output end 2112. In this case, in the case in which the first signal is input to the signal input end 2111, the signal for turning-on the second switch 2130 may be blocked. Otherwise, the signal for turning-on the second switch 2130 may be output.

Meanwhile, power driving the switch control unit 2110 may be received from the power supply unit 100 described above. To this end, the switch control unit 2110 may further include a power input unit 2113.

A description of a content overlapped with that of the exemplary embodiment of the present invention described above will be omitted.

In a method of preventing a false operation of an IC device according to the exemplary embodiment of the present invention, when the first signal is output from the first output end 1220 of the main IC 1200 for a predetermined time or more, the power supplied to the power input end 1210 of the main IC 1200 may be blocked.

Here, the first signal may be an H signal. When the H signal is output for a predetermined time or more, it is judged that the main IC 1200 is falsely operated to block the power supplied to the main IC 1200 and then supply again the power, thereby making it possible to allow the main IC 1200 to be power-on-reset.

Therefore, when a false operation that a power on state is maintained even though the main IC 1200 has entered the sleep mode occurs, the power provided to the main IC 1200 is automatically blocked to reset the main IC 1200, thereby making it possible to allow the main IC 1200 to be normally operated. As a result, the false operation of the main IC 1200 may be prevented and unnecessary power consumption may be decreased.

## Claims

1. An integrated circuit (IC) device comprising:
a power supply unit;
a main IC including a power input end receiving power and a first output end outputting a first signal in an active mode and outputting a second signal in a sleep mode; and
a power transferring unit connected to the power supply unit, the power input end, and the first output end and supplying the power to the main IC or blocking the power supplied to the main IC,
wherein the power transferring unit blocks the power supplied to the power input end when the first signal is continued for a predetermined time or more.

2. The IC device according to claim 1, wherein the power transferring unit includes a delay circuit, a regulator, and a first switch.

3. The IC device according to claim 2, wherein the regulator includes a first control terminal, an input terminal connected to the power supply unit, and an output terminal connected to the power input end,
the first switch has one end grounded and the other end connected to the first control terminal, and
the delay circuit includes an input unit connected to the first output end and an output unit connected to a control terminal of the first switch and outputs a signal input to the input unit to the output unit after a predetermined delay time elapses.

4. The IC device according to claim 3, wherein the first signal is an H signal and the second signal is an L signal.

5. The IC device according to claim 2, wherein the first signal is an H signal and the second signal is an L signal,
the regulator includes a first control terminal, an input terminal connected to the power supply unit, and an output terminal connected to the power input end and allows a voltage output to the output terminal to be 0 in the case in which a voltage applied to the first control terminal is 0,
the first switch has one end grounded and the other end connected to the first control terminal,
the delay circuit includes an input unit connected to the first output end and an output unit connected to a control terminal of the first switch and outputs a signal of which a magnitude of a voltage is increased at a predetermined ratio to the output unit when the H signal is applied to the input unit, and
the first switch is changed into a turn-on state when the magnitude of the voltage of the signal applied to the control terminal of the first switch becomes a predetermined reference value or more.

6. The IC device according to claim 5, further comprising a resistor connected between the other end of the first switch and the power supply unit.

7. The IC device according to claim 1, wherein the power transferring unit includes a delay circuit, a second switch, and a switch control unit.

8. The IC device according to claim 7, wherein the second switch has one end connected to the power supply unit and the other end connected to the power input end and include a second control terminal,
the switch control unit includes a signal output end connected to the second control terminal and a signal input end connected to an output unit of the delay circuit, outputs a signal for turning on the second switch to the signal output end, and blocks the output of the signal output end when the first signal is input to the signal input end, and
the delay circuit includes an input unit connected to the first output end and an output unit connected to the signal input end of the switch control unit and outputs a signal input to the input unit to the output unit after a predetermined delay time elapses.

9. The IC device according to claim 8, wherein the switch control unit further includes a power input unit connected to the power supply unit.

10. The IC device according to claim 8, wherein the first signal is an H signal and the second signal is an L signal.

11. A method of preventing a false operation of an IC device including a main IC including a power input end receiving power and a first output end outputting a first signal in an active mode and outputting a second signal in a sleep mode and a power supply unit, comprising:
blocking the power supplied to the power input end when the first signal is output from the first output end for a predetermined time or more.

12. The method according to claim 11, wherein the first signal is an H signal and the second signal is an L signal.
